(19) Europäisches Patentamt / European Patent Office / Office européen des brevets

(11) **EP 2 551 920 B1**

(12) **EUROPEAN PATENT SPECIFICATION**

(45) Date of publication and mention
of the grant of the patent:
**10.04.2019 Bulletin 2019/15**

(51) Int Cl.:
*H01L 31/09* (2006.01)          *H01L 31/0304* (2006.01)
*H01L 31/18* (2006.01)          *H03K 17/78* (2006.01)

(21) Application number: **12174508.7**

(22) Date of filing: **29.06.2012**

(54) **SEMICONDUCTOR DEVICE FOR OPTOELECTRONIC SWITCHING**

HALBLEITERVORRICHTUNG FÜR OPTOELEKTRONISCHES SCHALTEN

DISPOSITIF DE COMMUTATION OPTOÉLECTRONIQUE À SEMICONDUCTEUR

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **27.07.2011 GB 201112977**

(43) Date of publication of application:
**30.01.2013 Bulletin 2013/05**

(73) Proprietor: **Thales Holdings UK Plc
Reading, Berkshire RG2 6GF (GB)**

(72) Inventors:
• **Graham, Chris S.
London, WC1E 7JE (GB)**
• **Seeds, Alwyn
London, WC1E 7JE (GB)**

(74) Representative: **Grant, David Michael et al
Marks & Clerk LLP
90 Long Acre
London WC2E 9RA (GB)**

(56) References cited:
**US-A1- 2004 145 026**

• MANGENEY J ET AL: "Continuous wave terahertz generation up to 2THz by photomixing on ion-irradiated In0.53Ga0.47As at at 1.55 um wavelengths wavelengths", APPLIED PHYSICS LETTERS, AMERICAN INSTITUTE OF PHYSICS, US, vol. 91, no. 24, 10 December 2007 (2007-12-10), pages 241102-241102, XP012104739, ISSN: 0003-6951, DOI: 10.1063/1.2817607

• MANGENEY J ET AL: "Ultrafast response ( 2.2 ps) of ion-irradiated InGaAs photoconductive switch at 1.55 um", APPLIED PHYSICS LETTERS, AMERICAN INSTITUTE OF PHYSICS, US, vol. 83, no. 26, 29 December 2003 (2003-12-29), pages 5551-5553, XP001196205, ISSN: 0003-6951, DOI: 10.1063/1.1633030

• CÁMARA MAYORGA I ET AL: "Terahertz photomixing in high energy oxygen- and nitrogen-ion-implanted GaAs", APPLIED PHYSICS LETTERS, AMERICAN INSTITUTE OF PHYSICS, US, vol. 91, no. 3, 19 July 2007 (2007-07-19), pages 31107-31107, XP012100126, ISSN: 0003-6951, DOI: 10.1063/1.2753738

• JOULAUD L ET AL: "Thermal stability of ion-irradiated InGaAs with (sub-) picosecond carrier lifetime", APPLIED PHYSICS LETTERS, AMERICAN INSTITUTE OF PHYSICS, US, vol. 82, no. 6, 10 February 2003 (2003-02-10), pages 856-858, XP012034732, ISSN: 0003-6951, DOI: 10.1063/1.1543231

• MICHAEL E ET AL: "Terahertz continuous-wave large-area traveling-wave photomixers on high-energy low-dose ion-implanted GaAs", APPLIED PHYSICS LETTERS, AMERICAN INSTITUTE OF PHYSICS, US, vol. 90, no. 17, 25 April 2007 (2007-04-25), pages 171109-171109, XP012094303, ISSN: 0003-6951, DOI: 10.1063/1.2722235

• BURR E P ET AL: "Wavelength conversion of 1.53-um-wavelength picosecond pulses in an ion-implanted multiple-quantum-well all-optical switch", OPTICS LETTERS, OPTICAL SOCIETY OF AMERICA, US, vol. 28, no. 6, 15 March 2003 (2003-03-15), pages 483-485, XP001162120, ISSN: 0146-9592

## Description

The present invention relates to ultra fast optoelectronic switching using telecommunications wavelengths, suitable for digital sampling of analog waveforms.

Existing optoelectronic switches for this purpose have used Gallium Arsenide-based material systems, which require the absorption of light at 800 - 1180nm wavelengths from lasers which are traditionally bulky and are limited in their use in the field. The technology for producing such Gallium Arsenide ultra fast materials with repeatable direct current and temporal characteristics is also problematic, and this has increased unit cost. Previous telecommunications wavelength switches have been created using heavy ion implantation of Indium Gallium Arsenide with Gold and Bromine, but the effect of the amorphous region, where implanted ions come to rest in the underlying Indium Phosphide substrate, has been detrimental to switch performance, because this layer is too conductive and defects can migrate into the switch active region with time, altering switch performance. This has been overcome by the removal of the amorphous region from the devices, but the removal of the layer produces very thin devices, typically much less than $100\mu m$, which are difficult to handle. Radio frequency transmission through these devices is also compromised by the very thin substrates that are produced.

Accordingly, the purpose of the present invention is to provide a reliable device responsive to laser sources at telecommunications wavelengths, which will allow for the system integration of the switching device, to give the device a smaller footprint at a lower cost, for the sampling of waveforms.

According to a first aspect of the present invention, there is provided a method of manufacturing a semiconductor switching device as set out in claim 1.

According to a second aspect of the present invention, there is provided a method of manufacturing an optoelectric switch according to claim 11.

The following publications provide background to the present invention, and may be referred to for more detailed explanation of the relevant technology:

### Sampling Switches

Optoelectronic Sampling Review paper:

G. C. Valley "Photonic analogue to digital converters" Optics Express, Vol. 15, Issue 5, pp. 1955-1982, March 2007 - Note: a lengthy document, section 6.1 gives an idea of the role of the photo-switch in A to D conversion.

Optoelectronic sample and hold circuit:

C. Sun, C. Wu, C. Chang et al. "A bridge type optoelectronic sample and hold circuit" IEEE Int. Symp. Circuits & Systems 1991. June 1991 pp.3003-3006

### Competing Technologies

Nitrogen Ion Implanted Gallium Arsenide:

M. Mikulics, E. A. Michael, M. Marso, M. Lepsa et al. "Traveling-wave photomixers fabricated on high energy nitrogen-ion-implanted GaAs" App. Phys. Letts vol.89, 0711030 (3 pp.)

Heavy Ion Implanted Indium Gallium Arsenide Switches:

J. Delagnes, P. Mounaix, H. Nemec, L. Fekete et al. "High Photocarrier mobility in ultrafast ion-irradiated In0.53Ga0.47As for terahertz applications" J. Phys. -App.Phys. Vol.42 195103 (6pp) Sept 2009

J Mangeney, and P.Crozat "Ion -irradiated In0.53Ga0.47As photoconductive antennas for THz generation and detection at 1.55 $\mu$m wavelength photoconductive antenna excited at 1.55 $\mu$m" C. R. Physique Vol. 9, pp.142-152, Oct.2007

Electrooptic sampler only not for sampling microwave signals:

L. Joulaud, J. Mangeney, N.Chimot et al. "A 210 GHz Bandwidth Electrooptic Sampler for Large Signal Characterization of InP-based Components" IEEE Photonic Tech. Letts. Vol. 17, no. 12, Dec. 2005

Low temperature grown Gallium Arsenide sampling switches:

J-M. Delord, J. F. Roux, J. L. Coutaz. C. Canseliet et al. "Sampling of RF signals with LTG-GaAs based MSM structures" European Conference on Lasers and Electro-Optics and the International Quantum Electronics Conference, CLEO, Munich, 2007.

J-M. Delord J-F. Roux, J-L. Coutaz and N. Breiul "Performance assessment of low temperature-grown GaAs-based optoelectronic devices dedicated to RF sampling applications" CLEO/Europe - EQEC 2009 - European Conference on Lasers and Electro-Optics and the European Quantum Electronics Conference, Baltimore, June 2009.

ErAs:InGaAs ultrafast switch:

F. Ospald, D. Maryenko, K. von Klitzing, D. C. Driscoll et al. "1.55 um ultrafast photoconductive switches based on ErAs:InGaAs" App. Phys. Letts. Vol.92, 131117 (3 pp.) April 2008

B. Sartorious, H. Roehle, H. Kunzel, J. Bottcher et al. "All-fiber terahertz time-domain spectrometer operating at 1.5 $\mu$m telecom wavelengths" Optics Express vol.16, No. 3, pp. 9565-9570 June 2008

## EL-2 carrier traps in GaAs and InGaAs

A Krotkus and Jean-Louis Coutaz "Non-stoichiometric semiconductor materials for terahertz optoelectronics applications" Semicond. Sci. Technol.vol. v.20 (2005) S142-S150 June 2005

Further relevant prior art concerning semiconductor switching device based on ion implantation of InGaAs is provided by:

- US 2004/145026 A1;
- J. Mangeney et al., "Continuous wave terahertz generation up to 2THz by photomixing on ion-irradiated In0.53Ga0.47 As at at 1.55 $\mu$m wavelengths wavelengths", Applied Physics Letters 91, 24, pp. 241102-241102;
- I. Cámara Mayorga et al., "Terahertz photomixing in high energy oxygen- and nitrogen-ion-implanted GaAs", Applied Physics Letters 91, 3, pp. 31107-31107; and
- J. Mangeney et al., "Ultrafast response (~2.2 ps) of ion-irradiated InGaAs photoconductive switch at 1.55 $\mu$m", Applied Physics Letters 83, 26, pp. 5551-5553.

Some competing technologies will now be described briefly, to place the invention in its context.

Competing Technologies

- Low temperature Grown GaAs (LT-GaAs) - this is an established ultra fast material that is only able to absorb light at wavelengths of 750nm to 1080nm - it requires bulky and expensive Ti-Sapphire lasers. It also requires an annealing stage to optimise the material.
- Ion implanted GaAs - ion implantation by Nitrogen etc. has been performed and has comparable performance to LT-GaAs but such materials still cannot absorb at short wavelengths.
- Low temperature grown InGaAs - due to surface recombination (causing long switch off times) and high leakage currents, this requires Beryllium (Be) doping and additional carrier absorption layers.
- Shallow ion implantation of InGaAs has been performed but the implanted ions reside in the light absorption area, causing changes in its electrical properties.
- Deep ion implantation by Hydrogen and heavy ions - has been successfully performed but the Hydrogen ion concentration must be exceptionally high which may result in surface damage while use of heavy ions normally requires substrate removal for stable performance due to the effects of the amorphous region upon the device performance.
- ErAs nanoparticles grown in an InGaAs superlattice - this is a complex structure which has concentrated for its application on terahertz emission and detection rather than on sampling switches.

Table 1 below provides a summary of the performance of competing materials indicating the applicable wavelength range and the suitability of the device as a sampling switch:

**TABLE 1**

| Material | Wavelengths /nm | Sampling Switch | Comments |
|---|---|---|---|
| LT-GaAs | 750-1180 | Yes | Cannot absorb at telecommunication wavelengths. Annealing required. |
| Ion Implanted GaAs | 750-1180 | No | Cannot absorb at telecommunication wavelengths. |
| LT-InGaAs | 1200-1600 | No | Be doping and carrier absorbing layers required. |
| Shallow Ion Implanted InGaAs | 1200-1600 | No | Annealing required to reform lattice. Implanted ions cause change to electrical properties |
| Heavy Ion implantation | 1200-1600 | No | Amorphous region effects performance may require substrate removal. Low mobility. |
| Nitrogen Implanted | 1200-1600 | Yes | Ultrafast high mobility material where amorphous region has no effect upon the device. |

The use of Nitrogen ion implantation to produce the device in accordance with the invention leads to material of consistent electrical and temporal characteristics which can be produced on a repeatable basis. In Nitrogen implanted devices, the inert nature of the amorphous region means that no substrate removal is required after implantation. This enables the devices to be robust, since no thinning is required, and this robustness provides a consistent radio frequency transmission characteristic over a range of substrate depths when using coplanar waveguides, for example.

The absorption of radiation of 1200 to 1600 nm wavelengths by Nitrogen-ion implanted Indium Gallium Arsenide absorbing regions produces photo carriers which reduce the device resistance to such an extent that it acts as a low resistance area in series for example with a 50 ohm character impedance waveguide. The non-illuminated resistance of the device is typically several kilohms, and its illuminated resistance is typically 100 ohms or less. By using high energy Nitrogen ion implantation, typically over 1MeV, the switch-off time of the device can be reduced to a few ps or less, and this short duration allows the device to be used as a sampling switch capable of Nyquist sampling for example of a 20 GHz waveform which is transmitted through the microwave planar waveguide.

In this context, Nitrogen ion "implantation" is intended to mean irradiation with a Nitrogen ion beam such that the radiation penetrates the Indium Gallium Arsenide layer and comes to rest outside that layer, typically within an adjacent Indium Phosphide substrate. Virtually no Nitrogen ions remain in the Indium Gallium Arsenide layer.

The device is switchable by 1200 to 1600 nm wavelength laser pulses to produce on and off states of electrical transmissivity which are required for waveform sampling. The switches embodying the invention are capable of ultra fast characteristics, such that the switch-off time can be below 10ps.

The present invention has distinct advantages over the competing technologies mentioned above, in that it absorbs light at the required wavelengths typical for telecommunications, it is simple in its design and manufacture, it has high carrier mobility, and it requires no processing steps for the removal of any residual implanted ions.

In order that the invention may be better understood, a preferred embodiment will now be described, by way of example only, with reference to the accompanying diagrammatic drawings, in which:

Fig. 1 is a graph of recombination time in seconds against trap density per cubic centimetre, measured for proton-irradiated Indium Gallium Arsenide;

Fig. 2a illustrates the layout of the device embodying the present invention having a mesa structure with interdigitated electrodes;

Fig. 2b illustrates the structure of an optoelectronic switch in accordance with the embodiment of Fig. 2a;

Fig. 2c illustrates, to an enlarged scale, the mesa structure of an alternative embodiment to that of Fig. 2a, illustrating the electrode gaps;

Fig. 3a illustrates a coplanar waveguide including an optoelectronic switch device as shown in Fig. 2c, the waveguide embodying the invention;

Fig. 3b shows the same switch but on a microstrip waveguide rather than a coplanar waveguide;

Figs. 4a to 4h illustrate diagrammatically the fabrication steps for a switch structure such as that of Fig. 2a;

Fig. 5 illustrates schematically the irradiation process using Nitrogen ions in accordance with the present invention;

Fig. 6 illustrates the degree of penetration of Nitrogen ions through the Indium Gallium Arsenide layer and into the Indium Phosphide substrate, showing target depth in micro metres, transverse to the plane of the substrate;

Fig. 7 is a graph of current in amps against Bias voltage for a switch device embodying the invention, when switched on;

Fig. 8 is a graph of voltage in mV against time in ps to show the temporal response of an optoelectronic switch device embodying the present invention, and illustrating the switch-off time in response to a 2ps 1.26 Watt peak laser pulse;

Fig. 9 is a graph of current in mA against Bias voltage to show the photoconductive behaviour of a switch device embodying the present invention, the device being biased at a voltage between 0 and 1 volt and either not illuminated ("dark current") or illuminated with a 1500nm laser, the illumination being at 10 mW, 20mW, 30mW, 40mW and 50mW; and

Fig. 10 illustrates a non-ohmic structure as an alternative to that of Fig. 2b.

An ultra fast optoelectronic switch embodying the invention, and illustrated below in greater detail with reference to the accompanying drawings, comprises a coplanar waveguide formed on a layer of $Indium_{0.53}$ $Gallium_{0.47}$ Arsenide grown epitaxially upon an underlying substrate of semi-insulating Indium Phosphide. The coplanar waveguide has parallel ground paths on either side of a conductor which forms a signal path. The signal path is broken, terminating at a pair of opposed electrodes which are coupled to respective ohmic conductive regions connected to the Indium Gallium Arsenide layer. This structure enables part of the Indium Gallium Arsenide layer selectively to switch on and off the path between the electrodes of the signal path. A picosecond or femtosecond laser of suitable wavelength is arranged over the device to project a laser beam onto the switch region, to cause the Indium Gallium Arsenide to switch the conductive path on and off. An input signal waveform at one end of the waveguide is thereby sampled to provide a sample of the input signal at the output.

The mechanism of switching is that the laser beam causes a rapid increase in electrical carriers in the Indium Gallium Arsenide material, so reducing its resistance. Once the laser beam is switched off, the electrical carriers are rapidly absorbed in the Indium Gallium Arsenide, in carrier traps as described in greater detail below, so switching off the device electrically. The off-state resistance is typically of the order of several kilohms, and its on-state resistance is designed to be around 50 ohms using the appropriate laser intensity to achieve this. The selection of 50 ohms is designed to be consistent with typical impedances used as a standard in radio frequency waveguides.

During the illumination of the device, a radio frequency signal at its input is transmitted on the 50 ohm transmission line signal path across the 50 ohm load and it is detected at the output of the device. Upon extinction of the pulse, the device reverts to high resistance and the input signal is attenuated. With appropriate holding and analog-to-digital circuitry, the sampled output may then be processed digitally.

In order to sample signals of at least several GHz, the switch-off time of the device must ideally be reduced to less than 10ps, and this is achieved, in accordance with the present invention, by greatly increasing the density of carrier traps in the photoconductive semiconductor material. By reducing the switch-off time, such high frequency signals may successfully be sampled, so that the sampled output provides an accurate digital profile of the analog input waveform.

In an ultra fast material such as Indium Gallium Arsenide, there is an intermediate level energy band pinned between the semiconductor conduction band and the valence band, and this intermediate level traps the photogenerated carriers during the recombination time, to allow the switch to switch off. This effect has been observed in LT GaAs, though the large band gap makes this material unsuitable for absorption at 1200 to 1600nm. LT- Indium Gallium Arsenide is an option, but this is too conductive. The present invention causes the generation of deep level defects in Indium Gallium Arsenide through Nitrogen ion irradiation, to generate ultra fast behaviour without the disadvantages of prior structures, and Indium Gallium Arsenide is switched at 1200 to 1600nm.

The recombination mechanism using the carrier traps is known as Shockley-Read-Hall recombination, and is described in greater detail in publications referred to above. This SRH recombination mechanism is dependent upon the presence of non-stoichiometric features within the semiconductor lattice. As with LT- Gallium Arsenide, this deep energy level in Indium Gallium Arsenide is created by the displacement of Gallium and Arsenic sites.

The reduction of the carrier recombination time in Indium Gallium Arsenide, from a few ns down to below 5ps and sometimes below 1ps can be achieved by the creation of the deep level defects by the irradiation with high energy Nitrogen ions. The majority of the trapping levels are caused by the interactions between disturbed interstitial Arsenic atoms and vacant Gallium sites. This mechanism is known as the EL-2 deep level defect.

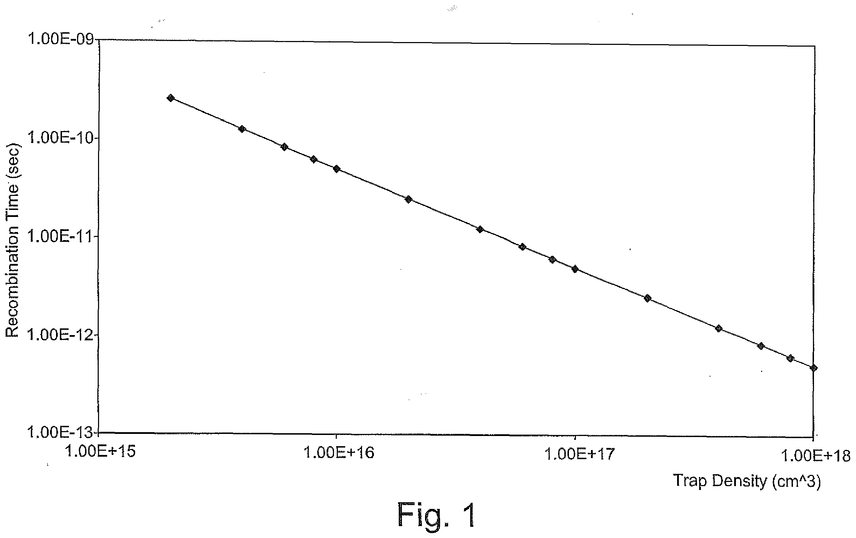

In all semiconductors, imperfections in the lattice structure will induce SRH recombination; however, the concentrations of these carrier traps have a negligible effect upon the photo carrier recombination time, as direct recombination is the major process. In ultra fast materials, the much-increased trap concentration can reduce the recombination time to sub ps durations. With reference to the graph shown in Fig. 1, using values for capture cross section and thermal velocity, in equation 1 below, measured for proton-irradiated Indium Gallium Arsenide, the carrier trap concentration for a recombination time of 1ps is expected to be about $5 \times 10^{17}$ cm$^{-3}$.

Equation 1:

$$\tau_\rho = \frac{1 + \left(\dfrac{2n_i}{n_{no}}\right)\cosh\left(\dfrac{E_t - E_i}{kT}\right)}{V_{th}\sigma_n N_t} \qquad \begin{array}{c} Room \\ temperature \\ \Longrightarrow \end{array} \qquad \tau_\rho \approx \frac{1}{V_{th}\sigma_n N_t}$$

where $\tau_\rho$ = recombination time, $V_{th}$ = carrier thermal velocity, $\sigma_n$ = capture cross section, and $N_t$ = trap density.

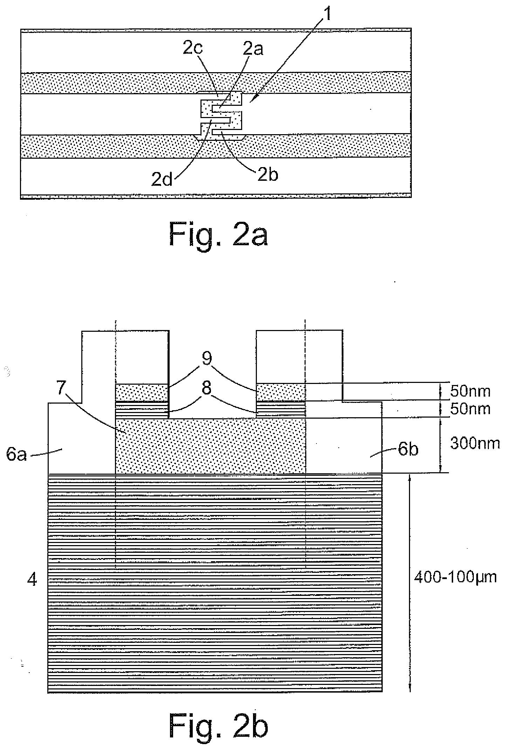

The structure of a switch device embodying the invention will now be described with reference to Figs. 2a to 2c. As shown in Fig. 2a, the signal path, shown as the central conductor between two ground conductors, is broken in such a way as to form a mesa structure with one pair of electrodes 2a, 2b at one end interdigitated with another pair of electrodes 2c, 2d at the other end. There is a substantially constant gap between the electrodes, to allow the Indium Gallium Arsenide material to selectively conduct electricity across that gap.

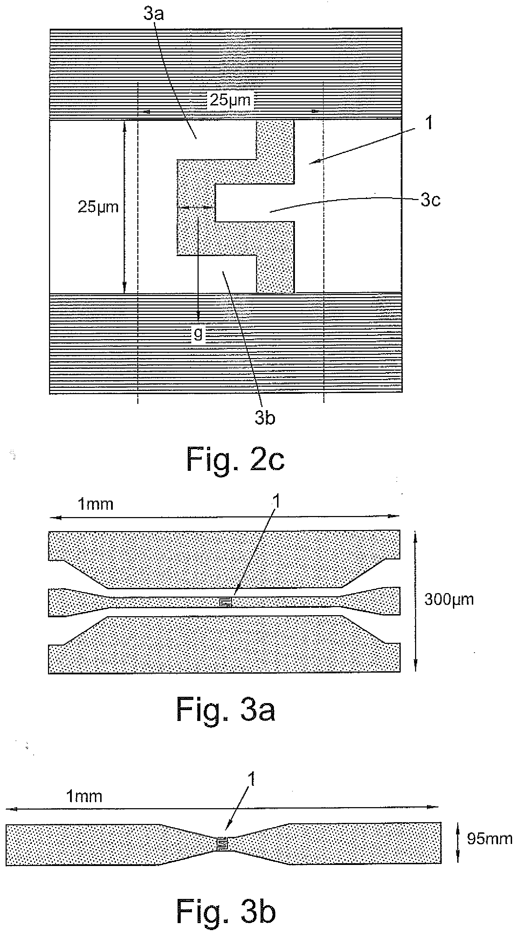

An alternative structure is shown in Fig. 2c, with one electrode 3c interdigitated with a pair of electrodes 3a, 3b on the other side, and a consistent gap g between the electrodes. In the example of Fig. 2c, the mesa structure 1 has dimensions approximately 25$\mu$m square.

In this embodiment the electrode gap g is typically in the range of 3-5$\mu$m depending on the design required although if suitable lithography is available it can advantageously be reduced to under 1 $\mu$m.

As shown in cross section in Fig. 2b, the device has a semi-insulating Fe: InP substrate 4 with a thickness of 400$\mu$m down to 100$\mu$m depending on the application required. Adjacent the substrate 4 is an earth plane 5 (not shown in Fig. 2b) of 20nm Cr and 250nm Au.

As described below, an upper layer of the substrate 4 is largely devoid of implanted Nitrogen ions, which instead come to rest in an amorphous region in a lower layer of the substrate.

The Indium Gallium Arsenide layer is formed as layer 7 in direct contact with, and bonded to, the Indium Phosphide layer 4, to a thickness typically of 300nm. A central portion of this layer 7 is exposed to allow it to be irradiated with Nitrogen ions, as described below.

On each side of the opening, there remains an n-InP etch stop layer 8 over the layer 7, and an n-Indium Gallium Arsenide ohmic layer 9 over layer 8. Each of the layers 8 and 9 has a thickness typically of 50nm. Electrodes 6a and 6b are formed on each side of the Indium Gallium Arsenide layer 7 and over the respective ohmic layers 9, and these electrodes are connected integrally to the waveguide conductors as described below with reference to Fig. 3.

A typical coplanar waveguide structure for radio frequency signals is shown in Fig. 3a, and in this example its width is 300$\mu$m. The width of the central conductor is 25$\mu$m, and the substrate thickness ranges from 100$\mu$m to 400$\mu$m, as in the example of Fig. 2b. The mesa structure active optoelectronic device 1 is shown at the centre of the waveguide in Fig. 3a.

A microstrip waveguide with a switch having the mesa structure 1 is shown in Fig. 3b, and in this example its length is 1mm and its width is 95$\mu$m.

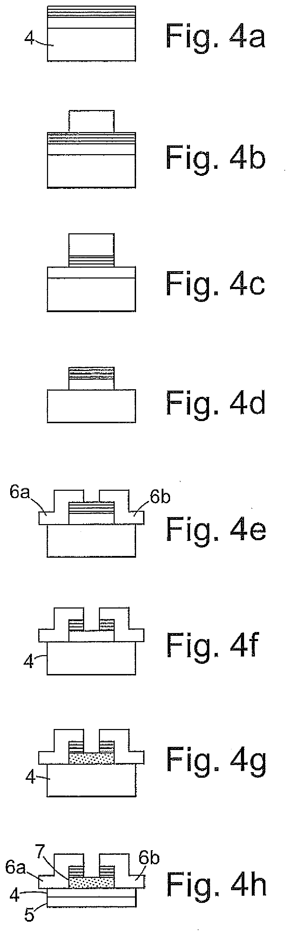

The manufacturing process of the device as described with reference to Figs. 2 and 3 will now be described with reference to Figs. 4a to 4h. As shown in Fig. 4a, an Indium Gallium Arsenide on Indium Phosphide wafer is prepared and cleaved, using organic and inorganic reagent cleaning. The next fabrication step is alignment mark pattern lithography and deposition of a 20nm Chromium layer and a 100nm Gold layer, to achieve the pattern shown in Fig. 4b. The next fabrication step is mesa pattern photo lithography, the pattern being aligned using alignment marks and a single layer resist. The next step is etching an ohmic layer mesa structure, shown in Fig. 4c. 50nm n-Indium Gallium Arsenide etching is performed with $H_3PO_4/H_2O_2/H_2O$ for 30 seconds. 50nm n-InP etching is performed by $H_3PO_4/HCl$ for 30 seconds.

The next fabrication step is etching an Indium Gallium Arsenide mesa structure of 300 nm thickness using $H_3PO_4/H_2O_2/H_2O$ for 3 minutes. This produces the structure shown in Fig. 4d.

The next stage is electrode and waveguide pattern exposure and development. Ultraviolet at 25 mJ/cm$^2$ exposure is undertaken for 5 seconds, and developed for 40 seconds. As shown in Fig. 4e, the next stage is electrode and waveguide deposition using 20nm Chromium and 350nm Gold deposition layers.

As shown in Fig. 4f, the next stage is ohmic layer removal in the electrode gap. This is achieved by 50nm n-Indium Gallium Arsenide etching by $H_3PO_4/H_2O_2/H_2O$ for 15 seconds, followed by 50nm n-Indium Phosphide etching by $H_3PO_4/HCl$ for 15 seconds.

The sample is then annealed by heating it to 400°C in a Nitrogen atmosphere for 5 minutes.

As shown in Fig. 4g, the next stage is Nitrogen ion implantation (irradiation) with the sample heated to 200°C in a vacuum. Nitrogen ions are irradiated in a beam at 4 MeV with a fluence of 10$^{13}$cm$^{-2}$.

As shown in Fig. 4h, the wafer is then thinned as required, and metallised. The substrate is removed selectively by $Al_2O_3$ abrasive down to 125μm thickness. A layer of 20nm Chromium and 250nm Gold is deposited for the earth plane.

Finally, the device is cleaved (not shown).

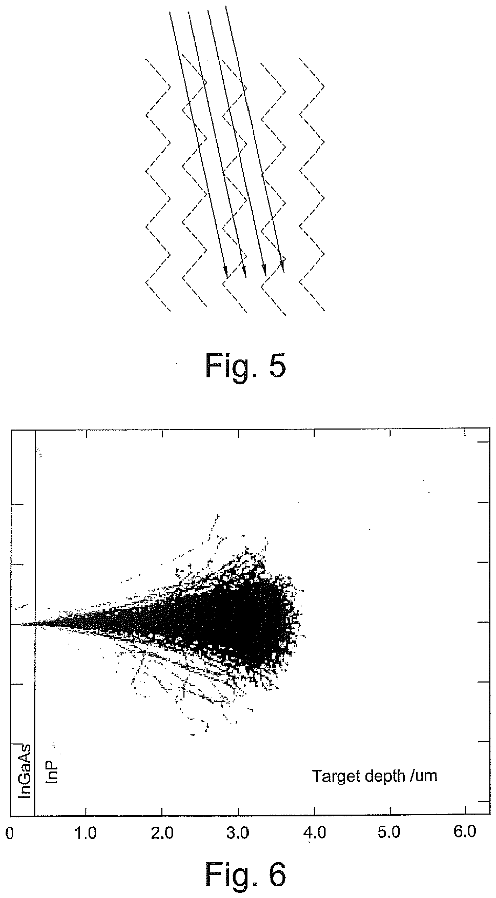

The ion irradiation is illustrated in Fig. 5, in which the ion beam, shown by arrows, is set at a 7° angle to the perpendicular to the substrate, in order to optimise the collision rate with the lattice. The sample is rotated by 22.5° to ensure a uniform collision profile. The lattice structure is symbolised with the jagged broken lines in Fig. 5.

Fig. 6 illustrates the absorption of the Nitrogen ion beam, as a function of target depth within the substrate. The Nitrogen ion beam at an energy of 1 MeV to 10 MeV, preferably about 4 MeV, and a fluence of 10$^{12}$ to 10$^{14}$cm$^{-2}$, preferably about 10$^{13}$cm$^{-2}$, penetrates the indium Gallium Arsenide layer (shown on the left hand side of the diagram) leaving virtually no Nitrogen ions in that layer. Less than approximately 1% of the Nitrogen ions are absorbed in the Indium Phosphide layer to a depth of less than 1μm, so that this layer, adjacent the Indium Gallium Arsenide layer, does not interfere with the switch. As shown in Fig. 6, most of the Nitrogen ions come to rest at a depth of between 2μm and 4μm in the substrate.

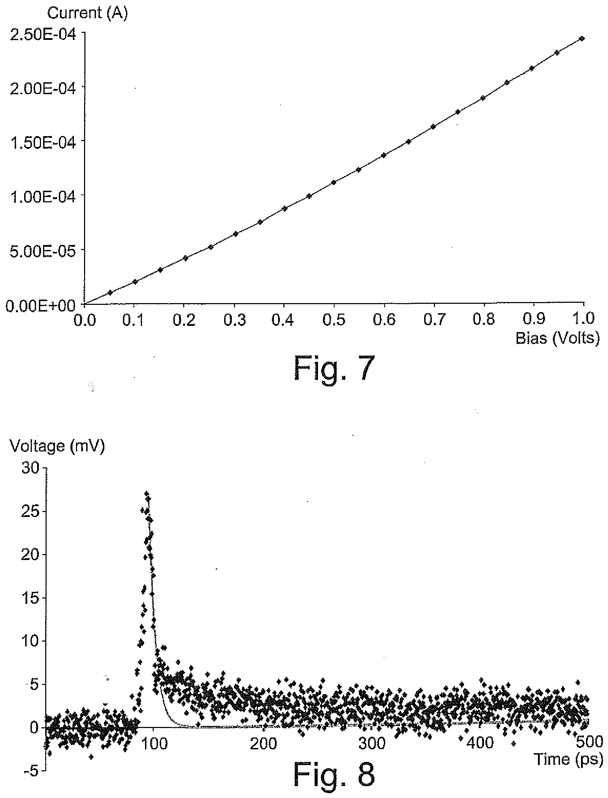

The direct current characteristic of the switch, formed in accordance with the invention, in its on state, is illustrated in Fig. 7, showing that its characteristic is largely ohmic. The implanted device carrier mobility was found to be around 9000 cm$^2$V$^{-1}$s$^{-1}$. This is significantly higher than the values that have been published (see the literature references above) for heavy ion implanted devices.

With reference to Fig. 8, which shows the temporal response of the implanted switch irradiated with a 2ps 1.26w peak laser pulse, the carrier recombination time at FWHM (Full Wave Half Maximum) is 5ps. Based on these measurements, the switch embodying the invention would be able to sample waveforms up to 20GHz in frequency and above. The graph shown in Fig. 8 can be represented by equation 2 below.

Equation 2:

$$v(t) = 23.8 \cdot \exp\frac{(-t)}{5\,ps}$$

where v is voltage and t is time.

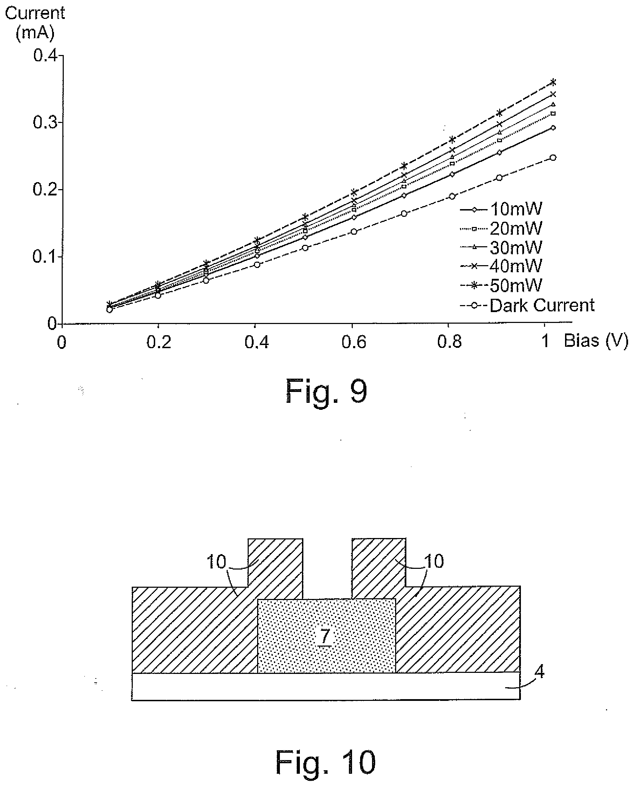

The performance of the device in its on and in its off states is illustrated in Fig. 9, showing current in mA against bias voltage, for different intensities of the illuminating laser beam at 1550nm. The six graphs show: dark current (not illuminated); and illuminated at powers of 10, 20, 30, 40 and 50 mW.

The capacitance of these optoelectronic switches was found to be at a maximum value of about 10fF, while the radio frequency response indicated that the switch capacitance on the 50 ohm coplanar waveguide was approximately 12fF. The measurement of the radio frequency output of the switch in the off state showed that the pre-implanted switch and the post-implanted switch had similar frequency responses, indicating that the relative permittivity of the implanted material at 13.9 had not been affected by the increased lattice defect number.

The carrier trap concentration should preferably be in the range of 10$^{16}$ to 10$^{19}$cm$^{-3}$, preferably about 5 x 10$^{17}$cm$^{-3}$.

The device may be used with 1200nm to 1600nm wavelength pulsed light to switch an electronic signal applied to one of the ohmic or non ohmic contact layers to generate an output digital signal which is effectively a sample of the input signal. It may be used to generate or detect pulses of less than 10ps width and optionally a few ps or even sub-picosecond width. This has applications in the sampling of microwave frequency signals.

An alternative structure to that of Fig. 2b is the non-ohmic contact layer mesa structure shown in Fig. 10, in which the layers are also not drawn to scale. A chromium/gold layer 10 forms the signal transmission line as well as the electrodes which contact the opposite sides of the active InGaAs layer 7. The mesa structure is formed by photolithography and selective acid etching. The electrodes are deposited by metal evaporation of 20 nm chromium and 350μm gold patterned by photolithography.

The invention is defined by the appended claims.

## Claims

1. A method of manufacturing a semiconductor switching device suitable for optoelectronic switching in response to light of wavelengths in the range 1200 nm to 1600 nm, comprising:

    forming an undoped InGaAs layer (7) on an insulative semiconductor substrate (4);
    bonding a pair of electrical contact layers on opposite sides of the InGaAs layer to form electrodes (2a, 2b, 2c, 2d, 3a, 3b, 3c) of the switching device; and
    forming bulk point defects by irradiating the InGaAs layer with Nitrogen ions;
    **characterized in that**
    the irradiation is at an energy such that the Nitrogen ions penetrate the InGaAs layer (7) and substantially all of the nitrogen ions come to rest outside the InGaAs layer in the underlying substrate (4).

2. A method according to claim 1, in which the implantation energy is in the range 1 MeV to 10 MeV.

3. A method according to claim 2, in which the implantation energy is substantially 4 MeV.

4. A method according to any preceding claim, in which the fluence of the irradiation with Nitrogen ions is in the range of $10^{12}$ to $10^{14}$ cm$^{-2}$.

5. A method according to any preceding claim, in which the irradiation is such that most of the Nitrogen ions come to rest within the substrate (4) between $1\mu$m and $4\mu$m, predominantly $2\mu$m to $4\mu$m, from the InGaAs layer (7).

6. A method according to any preceding claim, in which the substrate comprises semi-insulating InP.

7. A method according to any preceding claim, in which the InGaAs layer (7) is of $In_xGa_yAs$ where x is 0.53 and y is 0.47.

8. A method according to any preceding claim, in which the InGaAs layer (7) has bulk point defects formed by irradiating the InGaAs layer (7) with the Nitrogen ions, wherein at said bulk point defects, some of the Gallium and Arsenic sites are displaced to constitute carrier traps, for Shockley-Read-Hall recombination of photogenerated carriers, by the interaction between the displaced interstitial As atoms and vacant Ga sites and in which the carrier trap concentration is in the range of $10^{16}$ cm$^{-3}$ to $10^{19}$ cm$^{-3}$.

9. A method according to any preceding claim, in which the substrate (4) thickness is in the range of $100\mu$m to 1mm.

10. A method according to any preceding claim, in which the InGaAs (7) layer has a thickness in the range of 100nm to $1\mu$m.

11. A method of manufacturing an optoelectronic switch comprising a waveguide for an electronic signal, the method comprising manufacturing a semiconductor switching device according to the steps of any one of the preceding claims.

12. A method of manufacture according to claim 11, in which the waveguide is a coplanar waveguide with a signal path between two ground paths.

13. A method of manufacture according to claim 11 or 12, in which the electrodes are interdigitated in a mesa structure (1).

14. A method of manufacture according to claim 13, in which the gap between the electrodes is in the range of $3\mu$m to $5\mu$m, or is in the range of $1\mu$m to $5\mu$m, or is below $1\mu$m.

## Patentansprüche

1. Verfahren zum Herstellen einer Halbleiterschaltvorrichtung, die zum optoelektronischen Schalten als Reaktion auf Licht von Wellenlängen im Bereich von 1200 nm bis 1600 nm geeignet ist, umfassend:

    Ausbilden einer undotierten InGaAs-Schicht (7) auf einem isolierenden Halbleitersubstrat (4);
    Verbinden eines Paars von elektrischen Kontaktschichten auf gegenüberliegenden Seiten der InGaAs-Schicht, um Elektroden (2a, 2b, 2c, 2d, 2d, 3a, 3b, 3c) der Schaltvorrichtung auszubilden; und
Ausbilden von Volumen-Punktdefekten durch Bestrahlen der InGaAs-Schicht mit Stickstoffionen;
**dadurch gekennzeichnet, dass**
die Bestrahlung mit einer solchen Energie erfolgt, dass die Stickstoffionen die InGaAs-Schicht (7) durchdringen und im Wesentlichen alle Stickstoffionen außerhalb der InGaAs-Schicht im darunter liegenden Substrat (4) zur Ruhe kommen.

2. Verfahren nach Anspruch 1, bei dem die Implantationsenergie im Bereich von 1 MeV bis 10 MeV liegt.

3. Verfahren nach Anspruch 2, bei dem die Implantationsenergie im Wesentlichen 4 MeV beträgt.

4. Verfahren nach einem der vorhergehenden Ansprüche, bei dem die Fluenz der Bestrahlung mit Stickstoffionen im Bereich von $10^{12}$ bis $10^{14}$ cm-2 liegt.

5. Verfahren nach einem der vorhergehenden Ansprüche, bei dem die Bestrahlung derart ist, dass die meisten der Stickstoffionen zwischen 1 $\mu$m und 4 $\mu$m, überwiegend 2 $\mu$m bis 4 $\mu$m, von der InGaAs-Schicht (7) entfernt innerhalb des Substrats (4) zur Ruhe kommen.

6. Verfahren nach einem der vorhergehenden Ansprüche, bei dem das Substrat halbisolierendes InP umfasst.

7. Verfahren nach einem der vorhergehenden Ansprüche, bei dem die InGaAs-Schicht (7) aus $In_xGa_yAs$ besteht, wobei x 0,53 und y 0,47 ist.

8. Verfahren nach einem der vorhergehenden Ansprüche, bei dem die InGaAs-Schicht (7) Volumen-Punktdefekte aufweist, die durch Bestrahlen der InGaAs-Schicht (7) mit den Stickstoffionen ausgebildet werden, worin an den Volumen-Punktdefekten einige der Gallium- und Arsen-Gitterplätze verschoben werden, um Trägerfallen für die Shockley-Read-Hall-Rekombination von durch Photonenabsorption erzeugten Trägern zu bilden, und zwar durch die Wechselwirkung zwischen den verschobenen As-Zwischengitteratomen und unbesetzten Ga-Gitterplätzen, und bei dem die Trägerfallenkonzentration im Bereich von $10^{16}$ cm$^{-3}$ bis $10^{19}$ cm-3 liegt.

9. Verfahren nach einem der vorhergehenden Ansprüche, bei dem das Substrat (4) eine Dicke im Bereich von 100 $\mu$m bis 1 mm aufweist.

10. Verfahren nach einem der vorhergehenden Ansprüche, bei dem die InGaAs-Schicht (7) eine Dicke im Bereich von 100 nm bis 1 $\mu$m aufweist.

11. Verfahren zum Herstellen eines optoelektronischen Schalters, der einen Wellenleiter für ein elektronisches Signal umfasst, wobei das Verfahren umfasst: Herstellen einer Halbleiterschaltvorrichtung gemäß den Schritten nach einem der vorhergehenden Ansprüche.

12. Verfahren zur Herstellung nach Anspruch 11, bei dem der Wellenleiter ein koplanarer Wellenleiter mit einem Signalpfad zwischen zwei Massepfaden ist.

13. Verfahren zur Herstellung nach Anspruch 11 oder 12, bei dem die Elektroden in einer Mesa-Struktur (1) verschränkt sind.

14. Verfahren zur Herstellung nach Anspruch 13, bei dem der Spalt zwischen den Elektroden im Bereich von 3 $\mu$m bis 5 $\mu$m liegt oder im Bereich von 1 $\mu$m bis 5 $\mu$m liegt oder unterhalb von 1 $\mu$m liegt.

**Revendications**

1. Procédé de fabrication d'un dispositif de commutation à semiconducteur qui convient pour une commutation opto-électronique en réponse à une lumière de longueurs d'onde dans la plage de 1200 nm à 1600 nm, comprenant :

la formation d'une couche en InGaAs non dopée (7) sur un substrat semiconducteur isolant (4) ;
la liaison d'une paire de couches de contact électrique sur des côtés opposés de la couche en InGaAs de manière à former des électrodes (2a, 2b, 2c, 2d, 3a, 3b, 3c) du dispositif de commutation ; et

la formation de défauts ponctuels dans la masse en irradiant la couche en InGaAs à l'aide d'ions d'azote ;
**caractérisé en ce que** :
l'irradiation est à une énergie qui est telle que les ions d'azote pénètrent à l'intérieur de la couche en InGaAs (7) et que sensiblement tous les ions d'azote viennent reposer à l'extérieur de la couche en InGaAs dans le substrat sous-jacent (4).

2. Procédé selon la revendication 1, dans lequel l'énergie d'implantation s'inscrit dans la plage de 1 MeV à 10 MeV.

3. Procédé selon la revendication 2, dans lequel l'énergie d'implantation est de sensiblement 4 MeV.

4. Procédé selon l'une quelconque des revendications qui précèdent, dans lequel la fluence de l'irradiation à l'aide d'ions d'azote s'inscrit dans la plage de $10^{12}$ à $10^{14}$ cm$^{-2}$.

5. Procédé selon l'une quelconque des revendications qui précèdent, dans lequel l'irradiation est telle que la plus grande part des ions d'azote viennent reposer à l'intérieur du substrat (4) entre 1 $\mu$m et 4 $\mu$m, de manière prédominante entre 2 $\mu$m et 4 $\mu$m, par rapport à la couche en InGaAs (7).

6. Procédé selon l'une quelconque des revendications qui précèdent, dans lequel le substrat comprend de l'InP semi-isolant.

7. Procédé selon l'une quelconque des revendications qui précèdent, dans lequel la couche en InGaAs (7) est en In$_x$Ga$_y$As, où x est égal à 0,53 et y est égal à 0,47.

8. Procédé selon l'une quelconque des revendications qui précèdent, dans lequel la couche en InGaAs (7) comporte des défauts ponctuels dans la masse qui sont formés en irradiant la couche en InGaAs (7) à l'aide d'ions d'azote, dans lequel, au niveau desdits défauts ponctuels dans la masse, certains des sites de gallium et d'arsenic sont déplacés de manière à ce qu'ils constituent des pièges de porteurs, pour une recombinaison de Shockley-Read-Hall de porteurs photogénérés, au moyen de l'interaction entre les atomes d'As interstitiels déplacés et des sites de Ga vacants, et dans lequel la concentration des pièges de porteurs s'inscrit dans la plage de $10^{16}$ cm$^{-3}$ à $10^{19}$ cm$^{-3}$.

9. Procédé selon l'une quelconque des revendications qui précèdent, dans lequel l'épaisseur du substrat (4) s'inscrit dans la plage de 100 $\mu$m à 1 mm.

10. Procédé selon l'une quelconque des revendications qui précèdent, dans lequel la couche en InGaAs (7) présente une épaisseur dans la plage de 100 nm à 1 $\mu$m.

11. Procédé de fabrication d'un commutateur opto-électronique qui comprend un guide d'ondes pour un signal électronique, le procédé comprenant la fabrication d'un dispositif de commutation à semiconducteur conformément aux étapes selon l'une quelconque des revendications qui précèdent.

12. Procédé de fabrication selon la revendication 11, dans lequel le guide d'ondes est un guide d'ondes coplanaire qui présente une voie de signal entre deux voies de masse.

13. Procédé de fabrication selon les revendications 11 ou 12, dans lequel les électrodes sont imbriquées selon une structure mesa (1).

14. Procédé de fabrication selon la revendication 13, dans lequel l'espace entre les électrodes s'inscrit dans la plage de 3 $\mu$m à 5 $\mu$m, ou s'inscrit dans la plage de 1 $\mu$m à 5 $\mu$m, ou est en deçà de 1 $\mu$m.

Fig. 1

Fig. 2a

Fig. 2b

### Fig. 2c

### Fig. 3a

### Fig. 3b

Fig. 4a

Fig. 4b

Fig. 4c

Fig. 4d

Fig. 4e

Fig. 4f

Fig. 4g

Fig. 4h

# Fig. 5

InGaAs | InP

Target depth /um

0    1.0    2.0    3.0    4.0    5.0    6.0

# Fig. 6

Fig. 7

Fig. 8

Fig. 9

Fig. 10

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 2004145026 A1

### Non-patent literature cited in the description

- **G. C. VALLEY.** Photonic analogue to digital converters. *Optics Express,* March 2007, vol. 15 (5), 1955-1982
- **C. SUN ; C. WU ; C. CHANG et al.** A bridge type optoelectronic sample and hold circuit. *IEEE Int. Symp. Circuits & Systems 1991,* June 1991, 3003-3006
- **M. MIKULICS ; E. A. MICHAEL ; M. MARSO ; M. LEPSA et al.** Traveling-wave photomixers fabricated on high energy nitrogen-ion-implanted GaAs. *App. Phys. Letts,* vol. 89 (0711030), 3
- **J. DELAGNES ; P. MOUNAIX ; H. NEMEC ; L. FEKETE et al.** High Photocarrier mobility in ultrafast ion-irradiated In0.53Ga0.47As for terahertz applications. *J. Phys. -App.Phys.,* September 2009, vol. 42 (195103), 6
- **J MANGENEY ; P.CROZAT.** Ion -irradiated In0.53Ga0.47As photoconductive antennas for THz generation and detection at 1.55 $\mu$m wavelength photoconductive antenna excited at 1.55 $\mu$m. *C. R. Physique,* October 2007, vol. 9, 142-152
- **L. JOULAUD ; J. MANGENEY ; N.CHIMOT et al.** A 210 GHz Bandwidth Electrooptic Sampler for Large Signal Characterization of InP-based Components. *IEEE Photonic Tech. Letts.,* December 2005, vol. 17 (12
- **J-M. DELORD ; J. F. ROUX ; J. L. COUTAZ ; C. CANSELIET et al.** Sampling of RF signals with LTG-GaAs based MSM structures. *European Conference on Lasers and Electro-Optics and the International Quantum Electronics Conference, CLEO,* 2007
- **J-M. DELORD ; J-F. ROUX ; J-L. COUTAZ ; N. BREIUL.** Performance assessment of low temperature-grown GaAs-based optoelectronic devices dedicated to RF sampling applications. *CLEO/Europe - EQEC 2009 - European Conference on Lasers and Electro-Optics and the European Quantum Electronics Conference,* June 2009
- **F. OSPALD ; D. MARYENKO ; K. VON KLITZING ; D. C. DRISCOLL et al.** 1.55 um ultrafast photoconductive switches based on ErAs:InGaAs. *App. Phys. Letts.,* April 2008, vol. 92 (131117), 3
- **B. SARTORIOUS ; H. ROEHLE ; H. KUNZEL ; J. BOTTCHER et al.** All-fiber terahertz time-domain spectrometer operating at 1.5 $\mu$m telecom wavelengths. *Optics Express,* June 2008, vol. 16 (3), 9565-9570
- **A KROTKUS ; JEAN-LOUIS COUTAZ.** Non-stoichiometric semiconductor materials for terahertz optoelectronics applications. *Semicond. Sci. Technol.,* June 2005, vol. 20, S142-S150
- **J. MANGENEY et al.** Continuous wave terahertz generation up to 2THz by photomixing on ion-irradiated In0.53Ga0.47 As at at 1.55 $\mu$m wavelengths wavelengths. *Applied Physics Letters,* vol. 91 (24), 241102-241102
- **I. CÁMARA MAYORGA et al.** Terahertz photomixing in high energy oxygen- and nitrogen-ion-implanted GaAs. *Applied Physics Letters,* vol. 91 (3), 31107-31107
- **J. MANGENEY et al.** Ultrafast response (~2.2 ps) of ion-irradiated InGaAs photoconductive switch at 1.55 $\mu$m. *Applied Physics Letters,* vol. 83 (26), 5551-5553